# EUROPEAN PATENT SPECIFICATION

(11) **EP 4 338 198 B1**
(45) Date of publication and mention of the grant of the patent: **21.05.2025**
(21) Application number: 21943463.6
(22) Date of filing: 31.05.2021
(51) Int. Cl.: H01L 21/56

(54) **METHOD OF MANUFACTURING ACTIVE RECONSTRUCTED WAFERS**
VERFAHREN ZUR HERSTELLUNG VON AKTIVEN REKONSTRUIERTEN WAFERN
PROCÉDÉ DESTINÉ À FABRIQUER DES PLAQUETTES ACTIVES RECONSTRUITES

(43) Date of publication of application: 20.03.2024
(73) Proprietor: Huawei Technologies Co., Ltd., Shenzhen, Guangdong 518129 (CN)
(72) Inventor: MULLER, Philippe, Shenzhen, Guangdong 518129 (CN); LIU, Zhe, Shenzhen, Guangdong 518129 (CN); CHEN, Zanfeng, Shenzhen, Guangdong 518129 (CN)
(74) Representative: Gill Jennings & Every LLP
(86) International application number: PCT/CN2021/097503
(87) International publication number: WO 2022/252087

(56) References cited:
- CN-A- 102 157 392
- CN-A- 111 293 112
- US-A1- 2013 228 917
- US-A1- 2013 228 917
- US-A1- 2016 276 325
- US-A1- 2016 276 325
- US-A1- 2016 300 797
- US-A1- 2021 066 279
- US-B1- 10 943 851

## Description

### TECHNICAL FIELD

The disclosure relates generally to semiconductor wafers, and more particularly, the disclosure relates to a method of manufacturing an active reconstructed wafer.

### BACKGROUND

In High Performance Computing (HPC) applications, multiples cores, memory and networking chips are employed, which results in huge chip size. Small pitch chip-chip IOs are required to reduce energy consumption, active interposers with signal amplification and network chips are needed together with heat management to limit the chip temperature during computing. Further to overcome the power consumption, interconnects are required to be scaled in order to reduce parasitics and allow low latency and energy efficient interconnects. The interconnection of a plurality of small chiplets inside a reconstructed wafer by the use fine pitch ReDistribution Layer (RDL) is based on polymer mold which is incompatible with high thermal post-processing such as direct bonding on top of the Fan-out wafer-level packaging (FoWLP) reconstructed wafer. Stacking of ultra-thin dies using Hybrid Bonding (HB) is possible on an interposer but the size of this interposer will lead to high cost and manufacturing limits (reticle size, non-stepped designs).

In order to save efficiently the cost of manufacturing such huge chip, multiple chiplets are aggregated together. Such reconstructed wafer allows to select the known good dies only, improving the overall yield since chip stacking is used. In order to save cost, known technology uses molding material. In such case, dies are placed on a tape or a temporary carrier, the front side on the glue material. A molding compound is then applied by various methods before grinding is performed to flatten the mold backside forming a new substrate. After temporary carrier removal, ReDistribution Layer (RDL) and interconnects are then manufactured. To stack further chiplets, micro-bumps are required in order to cope with large warpage that might occur due to the Coefficient of Thermal Expansion (CTE) mismatch of the molding compound. However, this reduces the capability of scaling the interconnects pitch without any possible Direct Bonding Interconnect (DBI) .

Another know technology uses a large silicon interposer with the RDL on top or active devices for signal amplification and multiplexing signals between the chiplets that will later be assembled. In this case, copper (Cu) pads can be manufactured using the damascene process with a good dielectric flatness control. This allows the bonding of chiplets to this large carrier wafer. Such interposer has however a large cost, even if the Complementary Metal Oxide Semiconductor (CMOS) used is not as scaled as the HPC chiplets. The total surface of such interposer reduces the chips per wafer and therefor the overall cost.

Therefore, there arises a need to address the aforementioned technical drawbacks and problems in manufacturing a reconstructed semiconductor wafer.

US 2013/228917 A1, US 2016/276325 A1, US 2021/066279 A1, US 10 943 851 B1 and US 2016/300797 A1 disclose methods of manufacturing a reconstructed semiconductor wafer according to the prior art.

### SUMMARY

It is an object of the disclosure to provide a method of manufacturing an active reconstructed wafer including a plurality of chiplets while avoiding one or more disadvantages of prior art approaches.

This object is achieved by the features of the independent claims. Further, implementation forms are apparent from the dependent claims, the description, and the figures.

The disclosure provides a method of manufacturing an active reconstructed wafer including a plurality of chiplets.

According to a first aspect, there is provided a method of manufacturing an active reconstructed wafer. The reconstructed wafer includes a plurality of chiplets. The method includes dicing a product wafer comprising chiplets to singulate the chiplets using plasma dicing on a glass carrier. The method includes selecting good dies for chiplets using laser release and a pick-up tool. The method includes bonding the selected good dies to a sacrificial wafer. The method includes filling gaps between chiplets thereby forming a first layer forming the active reconstructed wafer. The method includes thinning of the selected good dies. The method includes bonding the reconstructed wafer to a silicon wafer. The method includes removing the sacrificial wafer. The method includes connecting chiplets. The method includes stacking further dies in at least one further layer. The method includes forming interconnects for attachment.

The method involves a simple integration process without molding compounds to realize the active reconstructed wafer. The method provides a cost-effective reconstructed interposer for advanced chip staking using Direct Bonding Interconnect (DBI). The method includes singulating smaller dies < 1 millimeter (mm) from a device wafer to separate known good dies and assembling them onto a Fan-out wafer-level packaging (FoWLP). The method avoids the use of expensive large active interposer, rather the active interposer is formed with the plurality of chiplets with the desired functions to interconnect a further memory, and processors. The method allows a thick passive substrate as a heat sink and allows extreme thinning of known good chiplets, thereby reducing total package thickness. This passive heat sink could be structured with micro-channels to allow active cooling. The method includes creating a new silicon active interposer using the plurality of chiplets and bare silicon pieces on a sacrificial silicon carrier that allows to concentrate the needed functions to 500 x 500 µm chiplets and lower down the cost of manufacturing, whereas the total interposer size can be few tens of centimeters (cm) in total. This allows also to thin down these chiplets to extreme that may help to cool down later-on the stacked integrated circuit (IC) in the case of, High Performance Computing (HPC). Cutting edge Chip-to-Wafer (C2W) die placement is required together with die overlay compensation with a biased pad layer. In such case, the <1 micrometer (µm) Line and space (LS) ReDistribution Layer (RDL) can be manufactured and bonding pads can be realized to further use Face to Back (F2B) or Face to Face (F2F) hybrid bonding of memory and high-performance logic chiplets are also thinned down to extreme in order to minimize the latency and energy per bit required for HPC applications. The active chiplets, as small as 500 µm, are bonded using the fusing bonding and precisely aligned using a C2W pick and placed with <400 nanometer (nm) overlay accuracy. The method does not use polymer molding material and the reconstructed wafer behaves like a normal silicon wafer compatible with standard Back End Off Line (BEOL) thermal budget for the post-processing and therefore also fully compatible with a standard BEOL line, and no specific packaging line is required.

Optionally, the product wafer is bonded using a temporary bonding layer on the glass carrier. Optionally, a photosensitive polymer is coated on the backside or the front side of the product wafer. Optionally, plasma dicing is realized and polymer mask is stripped before taping and laser exposure of the Temporary Bonding Material (TBM) to transfer the plasma diced chiplets to the frame. The wafer is diced by plasma on the glass carrier with a laser release layer optimized to avoid die destruction due to laser induced acoustic shock-waves.

The sacrificial wafer is silicon-based and patterned with fiducials. The known good dies are bonded on the sacrificial wafer of silicon with fiducials to have perfect placement accuracy, thinning capabilities, and stability together with a high-quality oxide filling of inter-die gaps.

Optionally, the method further includes bonding the selected good dies to the sacrificial wafer by fusion bonding. Optionally, the method further includes filling gaps between chiplets utilizing SOG (Spin-On Glass). Optionally, the method further includes depositing a backside passivation layer in order to bond the new silicon wafer on a back side of the active reconstructed wafer. The sacrificial layer is formed on a front side of the active reconstructed wafer. Optionally, the chiplets are smaller than 500 micrometers.

Optionally, the method further includes removing the sacrificial wafer by grinding and CMP (Chemical and Mechanical Polishing). The dies are perfectly fixed for the first gap filling with Spin-On Glass (SOG), grinding and Chemical and Mechanical Polishing (CMP) to reach silicon thickness of 5 µm without etch stop layer, and few tens of nm when using die manufactured on Silicon on Insulator (SOI) or with epitaxial etch stop layer below the active silicon layer such as Silicon Germanium (SiGe) or similar layer. All dies are thinned eventually to an extreme thickness down to a few tens of nm, therefore only oxide fusion bonding can be applicable for good Total Thickness Variation (TTV) and roughness control.

Optionally, the method further includes connecting the chiplets together with fine pitch RDL. Damascene RDL based on advanced lithography is used to interconnect the chiplets. Damascene RDL can then be performed using a die shift compensation first. With such overlay compensation, it is then possible to connect the chiplets together with fine pitch RDL and prepare fine pitch copper (Cu) pads for further die-stacking.

Optionally, the method further includes stacking further dies in at least one further layer includes preparing fine pitch pads for the further die-stacking. Optionally, forming interconnects for the chiplets includes performing Through Silicon Via (TSV) to access Inputs/Outputs (IO)-connections of the chiplets and to realize the interconnects, optionally from the back-side of the chiplet to the bond-interface of the assembled chiplets (so called VIA-LAST TSV) or used an existing TSV performed from the frontside of the chiplet before assembly. This existing TSV will be released by thinning down the assembled chiplet from the back-side after bonding (also called VIA-MIDDLE or VIA-FIRST TSV). Optionally, the method further includes stacking further dies in at least one further layer by: selecting further good dies for further chiplets, bonding the selected further good dies to the reconstructed wafer, filling gaps between the further chiplets thereby forming a further layer, thinning of the selected good dies and connecting the further chiplets through damascene RDL and the TSV.

Therefore, according to the method of manufacturing the active reconstructed wafer including the plurality of chiplets, a new silicon active interposer using chiplets and optionally bare silicon pieces on a sacrificial silicon carrier is created that allows to concentrate the needed functions to 500 x 500 µm-size chiplets or below and lower down the cost of manufacturing, where the total interposer size can be few tens of cm in total. The thinning down of chiplets to extreme helps to minimize the latency and energy per bit required for High Performance Computing (HPC) applications.

These and other aspects of the disclosure will be apparent from and the implementation(s) described below.

### BRIEF DESCRIPTION OF DRAWINGS

Implementations of the disclosure will now be described, by way of example only, with reference to the accompanying drawings, in which:
FIGS. 1A-1B are flow diagrams that illustrate a method of manufacturing an active reconstructed wafer including a plurality of chiplets in accordance with an implementation of the disclosure;
FIGS. 2A-F are exemplary diagrams that illustrate a process of die singulation of a wafer to provide known good chiplets in accordance with an implementation of the disclosure; and
FIG. 3 is an exemplary diagram that illustrates stacked dies that would be bonded to a silicon interposer with microchannels embedded in its substrate in accordance with an implementation of the disclosure.

### DETAILED DESCRIPTION OF THE DRAWINGS

Implementations of the disclosure provide a method of manufacturing an active reconstructed wafer including a plurality of chiplets.

To make solutions of the disclosure more comprehensible for a person skilled in the art, the following implementations of the disclosure are described with reference to the accompanying drawings.

Terms such as "a first", "a second", "a third", and "a fourth" (if any) in the summary, claims, and foregoing accompanying drawings of the disclosure are used to distinguish between similar objects and are not necessarily used to describe a specific sequence or order. It should be understood that the terms so used are interchangeable under appropriate circumstances, so that the implementations of the disclosure described herein are, for example, capable of being implemented in sequences other than the sequences illustrated or described herein. Furthermore, the terms "include" and "have" and any variations thereof, are intended to cover a non-exclusive inclusion. For example, a process, a method, a system, a product, or a device that includes a series of steps or units, is not necessarily limited to expressly listed steps or units but may include other steps or units that are not expressly listed or that are inherent to such process, method, product, or device.

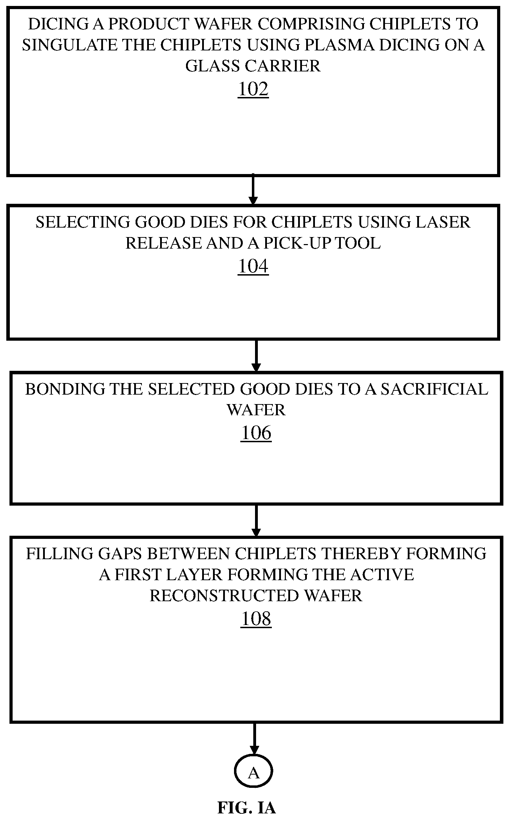

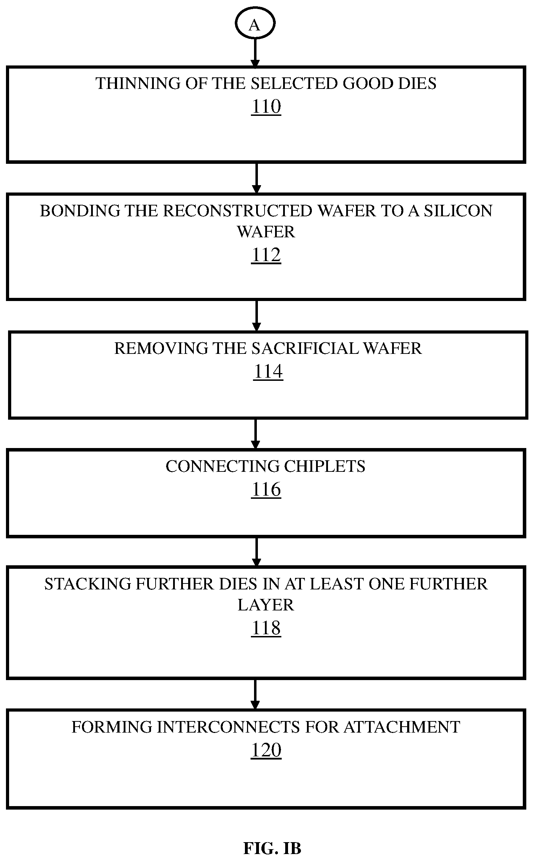

FIGS. 1A-1B are flow diagrams that illustrate a method of manufacturing an active reconstructed wafer including a plurality of chiplets in accordance with an implementation of the disclosure. At a step **102,** a product wafer including chiplets is diced to singulate the chiplets using plasma dicing on a glass carrier. At a step **104,** good dies for chiplets are selected using laser release and a pick-up tool. At a step **106,** the selected good dies are bonded to a sacrificial wafer. At a step **108,** gaps between chiplets are filled thereby forming a first layer forming the active reconstructed wafer. At a step **110,** the selected good dies are thinned. At a step **112,** the reconstructed wafer is bonded to a silicon wafer. At a step **114,** the sacrificial wafer is removed. At a step **116,** the chiplets are connected. At a step **118,** dies are further stacked in at least one further layer. At a step **120,** interconnects are formed for attachment.

The method involves a simple integration process without molding compounds to realize the active reconstructed wafer. The method provides a cost-effective reconstructed interposer for advanced chip staking using Direct Bonding Interconnect (DBI). The method includes singulating smaller dies < 1 millimeter (mm) from a device wafer to separate known good dies and assembling them onto a Fan-out wafer-level packaging (FoWLP). The method avoids the use of expensive large active interposer, rather the active interposer is formed with the plurality of chiplets with the desired functions to interconnect a further memory, and processors. The method allows a thick passive substrate as a heat sink and allows extreme thinning of known good chiplets, thereby reducing total package thickness. This passive heat sink could be structured with micro-channels to allow active cooling. The method includes creating a new silicon active interposer using the plurality of chiplets and bare silicon pieces on a sacrificial silicon carrier that allows to concentrate the needed functions to 500 x 500 µm chiplets and lower down the cost of manufacturing, whereas the total interposer size can be few tens of centimeters (cm) in total. This allows also to thin down these chiplets to extreme that may help to cool down later-on the stacked integrated circuit (IC) in the case of, High Performance Computing (HPC). Cutting edge Chip-to-Wafer (C2W) die placement is required together with die overlay compensation with a biased pad layer. In such case, the <1 micrometer (µm) Line and space (LS) ReDistribution Layer (RDL) can be manufactured, and bonding pads can be realized to further use Face to Back (F2B) or Face to Face (F2F) hybrid bonding of memory and high-performance logic chiplets are also thinned down to extreme in order to minimize the latency and energy per bit required for HPC applications. The active chiplets, as small as 500 µm, are bonded using the fusing bonding and precisely aligned using a C2W pick and placed with 400 nanometer (nm) overlay accuracy. The method does not use polymer molding material and the reconstructed wafer behaves like a normal silicon wafer compatible with standard Back End Off Line (BEOL) thermal budget for the post-processing and therefore also fully compatible with a standard BEOL line, and no specific packaging line is required.

Optionally, the product wafer is bonded using a temporary bonding layer on the glass carrier. Optionally, a photosensitive polymer is coated on the backside or the front side of the product wafer. Optionally, plasma dicing is realized, and polymer mask is stripped before taping and laser exposure of the Temporary Bonding Material (TBM) to transfer the plasma diced chiplets to the frame. The wafer is diced by plasma on the glass carrier with laser release layer optimized to avoid die destruction due to laser induced acoustic shock-waves.

The sacrificial wafer is silicon-based and patterned with fiducials. The known good dies are bonded on the sacrificial wafer of silicon with fiducials to have perfect placement accuracy, thinning capabilities, and stability together with a high-quality oxide filling of inter-die gaps.

Optionally, the method further includes bonding the selected good dies to the sacrificial wafer by fusion bonding. Optionally, the method further includes filling gaps between chiplets utilizing SOG (Spin-On Glass). Optionally, the method further includes depositing a backside passivation layer in order to bond the new silicon wafer on a back side of the active reconstructed wafer. The sacrificial layer is formed on a front side of the active reconstructed wafer. Optionally, the chiplets are smaller than 500 micrometers.

Optionally, the method further includes removing the sacrificial wafer by grinding and CMP (Chemical and Mechanical Polishing). The dies are perfectly fixed for the first gap filling with Spin-On Glass (SOG), grinding and Chemical and Mechanical Polishing (CMP) to reach silicon thickness of 5 µm without etch stop layer, and few tens of nm when using die manufactured on Silicon on Insulator (SOI) or with epitaxial etch stop layer below the active silicon layer such as Silicon Germanium (SiGe) or similar layer. All dies are thinned eventually to an extreme thickness down to a few tens of nm, therefore only oxide fusion bonding can be applicable for good Total Thickness Variation (TTV) and roughness control.

Optionally, the method further includes connecting the chiplets together with fine pitch RDL. Damascene RDL based on advanced lithography is used to interconnect the chiplets. Damascene RDL can then be performed using a die shift compensation first. With such overlay compensation, it is then possible to connect the chiplets together with fine pitch RDL and prepare fine pitch copper (Cu) pads for further die-stacking.

Optionally, the method further includes stacking further dies in at least one further layer includes preparing fine pitch pads for the further die-stacking. Optionally, forming interconnects for the chiplets includes VIA last Through Silicon Via (TSV) to access Inputs/Outputs (IO)-connections of the chiplets and to realize the interconnects, optionally from the back-side of the chiplet to the bond-interface of the assembled chiplets (so called VIA-LAST TSV) or used an existing TSV performed from the frontside of the chiplet before assembly. This existing TSV may be released by thinning down the assembled chiplet from the back-side after bonding (also called VIA-MIDDLE or VIA-FIRST TSV). Optionally, the method further includes stacking further dies in at least one further layer by: selecting further good dies for further chiplets, bonding the selected further good dies to the reconstructed wafer, filling gaps between the further chiplets thereby forming a further layer, thinning of the selected good dies, and connecting the further chiplets through damascene RDL and the TSV.

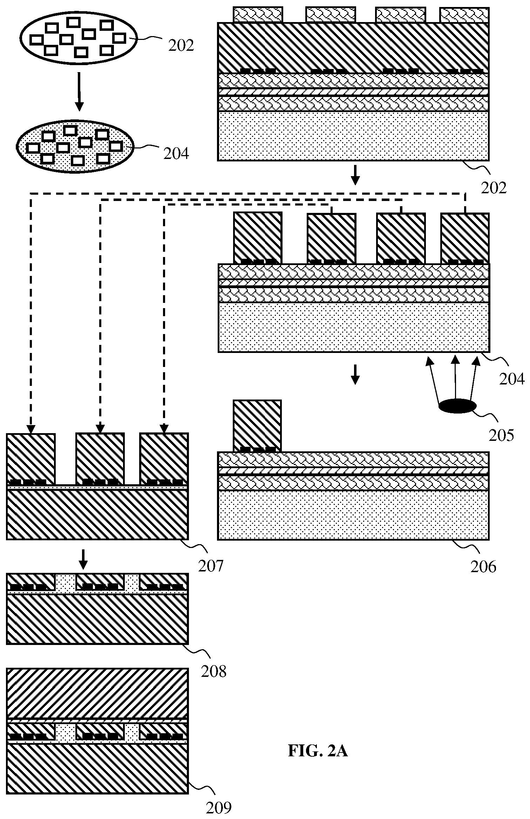

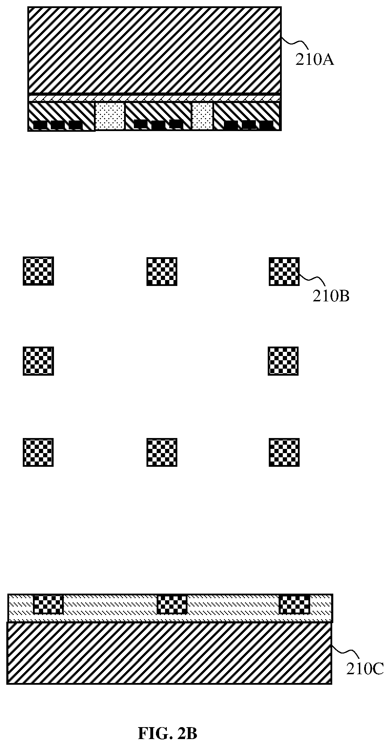

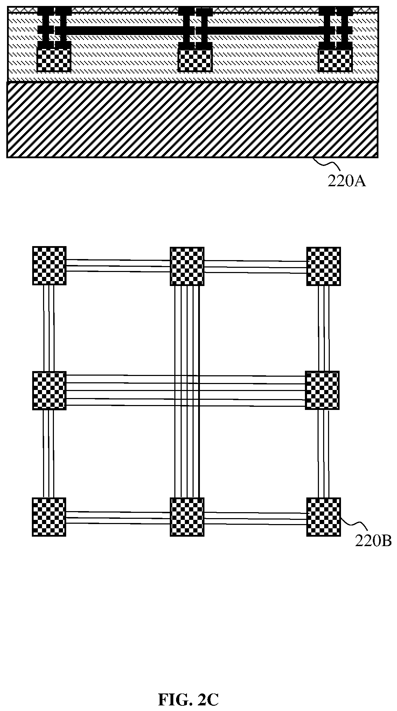

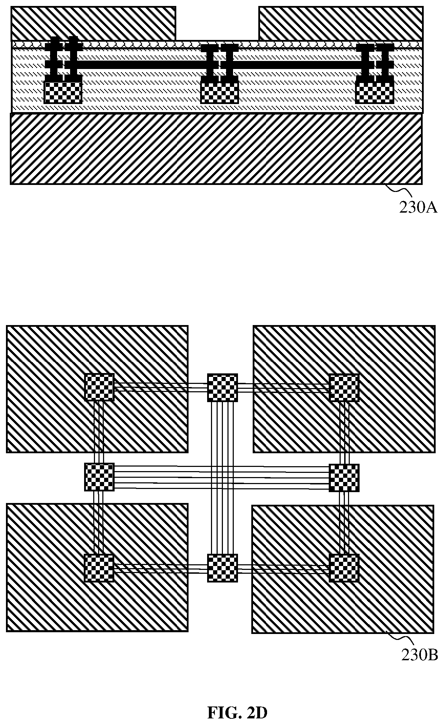

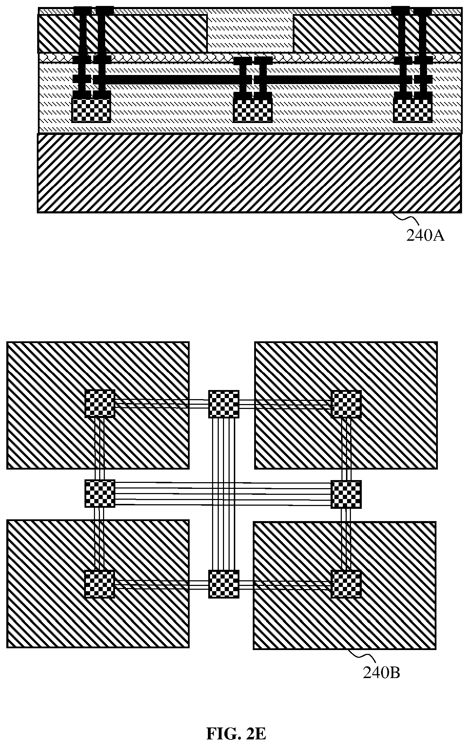

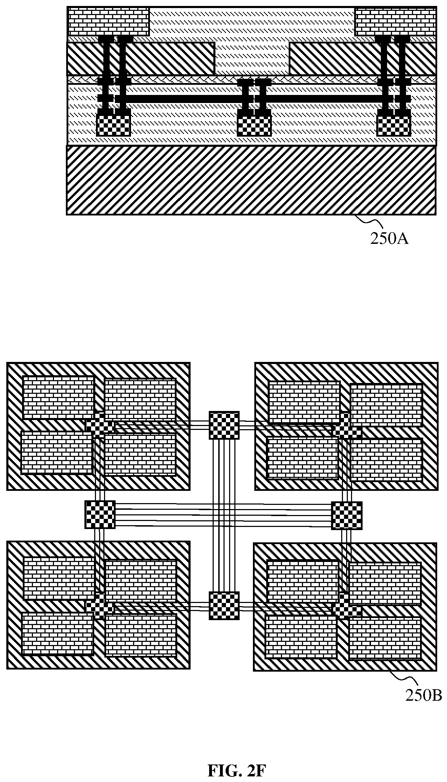

FIGS. 2A-F are exemplary diagrams that illustrate a process of die singulation of a wafer to provide known good chiplets in accordance with an implementation of the disclosure. At **202,** the wafer containing the chiplets is bonded face to face to a glass carrier wafer coated with a temporary bonding material, a laser release material and an acoustic attenuation material. A photosensitive compound is deposited and patterned by lithography to protect the chiplet active areas. At **204,** Deep silicon etching is realized and the photosensitive compound is removed. At **205,** Laser UV is used to irradiate the laser release layer through the glass carrier substrate. At **206,** bad dies remain still on the glass carrier wafer. At **207,** the good dies are picked and placed to the temporary silicon carrier wafer using fiducials to align the dies precisely on its surface. At **208,** oxide layer is deposited to fill the gaps between the bonded chiplets. Grinding and polishing thin down the dies and flatten the oxide between the chiplets. Optionally, connections can be patterned from the back-side of the chiplets to interconnects them. Otherwise, at **209,** a bon-dielectric is deposited and a new silicon substrate is bonded to the reconstructed wafer. At **210A-C,** the temporary silicon carrier is removed by grinding and polishing. At **220A-B,** interconnects can then be performed on the front side of the chiplets before pads are defined in a bond-dielectric. At **230A-B,** new dies are bonded and, at **240A-B,** oxide filling is performed and vias are patterned then filled with metal to make connections available for a new stacking at **250A-B.** Bumps for interconnecting the chip to a printed circuit board (PCB) can be realized either form the top-side or the bottom side of the stack. After bump manufacturing, the reconstructed wafer is diced.

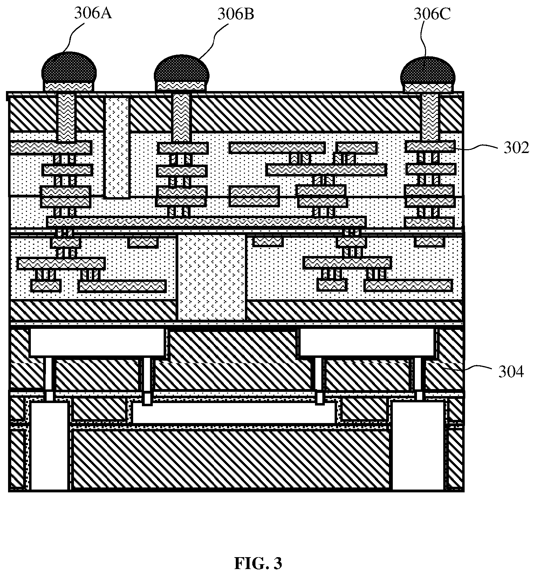

FIG. 3 is an exemplary diagram that illustrates stacked dies that would be bonded to a silicon interposer with micro channels embedded in its substrate in accordance with an implementation of the disclosure. The device with microchannels embedded in the substrate includes a reconstructed stacked chiplets interconnected with several embedded redistribution layers **302,** a liquid-cooled silicon wafer **304,** and bumps **306A-C.** Optionally, a reconstructed interposer is also compatible with an integration of embedded microfluidic channels to allow cooling of High-Performance Computing (HPC) chips. Optionally, ultra-thin Si chiplets forms a Fan-out wafer-level packaging (FoWLP) with wafer-level RDL **302** on top and supported by the liquid-cooled silicon wafer **304.** Multiple layered chips are bonded on top of the FoWLP wafer using direct bonding interconnect (DBI) and VIA last Through Silicon Via (TSV). The Bumps **306A-C** may build on top of a last layer of the chiplets for further printed circuit board (PCB) assembly. The Bumps **306A-C** may be uBumps of C4. Optionally, interconnects are performed using VIA last or VIA middle and form the C4 bumps on top of the top dies. VIA last TSV are performed to access IOs and realize at the end uBumps for assembly to a PCB board.

In an exemplary process, at least one of a dielectric and Chemical and Mechanical Polishing (CMP) is performed to flatten a probe tip marking in pads. Optionally, an extra pad damascene layer is added. A dielectric layer is then deposited on top of the pads and a dielectric CMP is performed in order to prepare a surface for a dielectric bonding. Photo patternable polymer is then deposited and pre-dicing plasma is performed in metal-free perimeter designed in dicing lanes. This step also allows to realize edge trimming required for the wafer thinning later on. After a polymer strip, Temporary Bonding Material (TBM) and laser release layers are deposited on a glass temporary carrier and possibly to a device wafer front side. This deposition may be performed by spin coating or wafer lamination. The wafer is then flipped and bonded to a glass carrier. Optionally, grinding and the CMP are performed to the target substrate-thickness of 50 micrometer (µm). At this step, back side passivation is performed and followed by a CMP to prepare the dielectric for fusion bonding. In the case of deep pre-dicing lanes, the dies may already be singulated. In the other example, a new polymer is spin coated and backside plasma dicing is performed. After cleaning and polymer strip, the glass carrier debonding is performed. Optionally, optimized temporary bond stack damps acoustic shockwaves generated by laser interaction with are lease layer, thereby preventing positive interfering standing acoustic waves that may break thinned dies.

The glass carrier is removed and known good dies are picked and placed to a new silicon substrate using its fiducials to precisely align the dies. This operation can be performed using an intermediate tray allowing to clean a bond dielectric or through 150°C annealing for 2 hours is performed in order to realize the dielectric bonds. A Spin On Glass or any other type of mineral dielectric layer is spin coated to fill the chiplets gaps. SOG curing is then performed to form a steady Silicone oxide (SiO₂) layer. Optionally, alternative Plasma-Enhanced Chemical Vapor Deposition, (PECVD) deposition is performed to fill the inter-chip gaps.

Grinding and the CMP are then performed to a target thickness for dies below 5 µm thickness, an etch stop layer such as buried silicon dioxide if the dies were manufactured on a SOI wafer, or an epitaxial layer such as Silicon Germanium below the active layer. The final Si release been performed by plasma etching or wet etching to avoid mechanical damage to the active layers. A dielectric layer may be deposited, and the CMP is performed before dielectric bonding to the final carrier. Then, silicone (Si) fusion bonding back to face (B2F) is performed and temporary carrier is removed by grinding and the CMP, and an overlay mapping of all dies is performed.

A dielectric layer is deposited and VIA are dry-etched to open the pad connection and realize a damascence filling with the following step: Barrier and seed layer for Cu plating are then deposited by Physical Vapor Deposition (PVD), Atomic Layer Deposition (ALD, or Chemical Vapor Deposition (CVD before the VIA bottom-up filling with Cu by Electro Chemical Deposition (ECD, followed by copper (Cu) sintering and Cu CMP. This first damascence layer can be optimized so that each die has a separate reticule exposure in order to compensate for die misalignment. Further damascene ReDistribution Layer (RDL) is then performed, the overlay correction may then allow having fine pitch RDL interconnects of dies.

Further die stacking is then possible in a face to face (F2F) assembly using hybrid bonding. Further, die stacking include Through Silicon Via (TSV)-middle where chiplets are bonded followed by a SOG gap filling, grinding, and CMP as for the first active interposer reconstruction but with plasma etching to expose the TSV. A passivation layer is then deposited, and a CMP is performed to open the TSV liner and allow interconnects at this stage. A repetition of this process may be performed with various RDL and die-placement compensation, or finish the process with micro bumps deposition in order to connect to a printed circuit board (PCB) board.

In another example, in standard dies without TSV-middle, the gap filling is performed, and silicon is removed by grinding and CMP. Possible extreme thinning can be performed to allow extremely dense TSV-last interconnects. Backside mask and dry etching are then performed stopping on the bond dielectric interface. Liner deposition is then performed and Plasma Enhanced Chemical Vapor Deposition (PECVD) nitride protection is deposited to allow bottom TSV-last opening. Optionally, two options are available for the TSV filling. First option is to use a no Silicon diffusion metal layer for the landing pad or deposit an embedded barrier and a second liner to avoid copper (Cu) resputtered atoms to diffuse to the silicon and Low k dielectrics as the bottom dielectric is removed and Cu pad is exposed to plasma. Barrier and seed layer are then deposited and Electro Chemical Deposition (ECD) of Cu filling is performed with both alkaline and acidic solutions to allow void free TSV bottom-up filling. Sintering and CMP are then performed to remove the excess of Cu and stabilize the structure. As for the second option, RDL can be deposited by damascene process and further die stacking can be performed or simple C4 bumps can be deposited to allow interconnects to laminate or interposers. Focussed Ion Beam (FIB), Scanning Electron Microscopy (SEM) and micro selection may be used to detect a presence of reconstructed active interposer with SOG filled inter chip gap and extreme thinned dies.

Although the disclosure and its advantages have been described in detail, it should be understood that various changes, substitutions, and alterations can be made herein without departing from the scope of the invention as defined by the appended claims.

## Claims

1. A method of manufacturing an active reconstructed wafer, the reconstructed wafer comprising a plurality of chiplets, the method **characterized in that** the method comprises:
dicing (102) a product wafer comprising chiplets to singulate the chiplets using plasma dicing on a glass carrier;
selecting (104) good dies for chiplets using laser release and a pick-up tool;
bonding (106) the selected good dies to a sacrificial wafer;
filling (108) gaps between chiplets thereby forming a first layer forming the active reconstructed wafer;
thinning (110) of the selected good dies;
bonding (112) the reconstructed wafer to a silicon wafer;
removing (114) the sacrificial wafer;
connecting (116) chiplets;
stacking (118) further dies in at least one further layer; and then forming (120) interconnects for attachment.

2. The method according to claim 1, wherein
the product wafer is bonded using a temporary bonding layer on the glass carrier,
a photosensitive polymer is coated on the backside or the front side of the product wafer,
plasma dicing is realized and polymer mask is stripped before taping and laser exposure of the Temporary Bonding Material (TBM) to transfer the plasma diced chiplets to the frame.

3. The method according to claim 1 or 2, wherein the sacrificial wafer is silicon-based and patterned with fiducials.

4. The method according to any preceding claim, wherein the method further comprises bonding the selected good dies to the sacrificial wafer by fusion bonding.

5. The method according to any preceding claim, wherein the method further comprises filling gaps between chiplets utilizing SOG (Spin-On Glass).

6. The method according to any preceding claim, wherein the method further comprises depositing a backside passivation layer in order to bond the new silicon wafer on a back side of the active reconstructed wafer and wherein the sacrificial layer is formed on a front side of the active reconstructed wafer.

7. The method according to any preceding claim, wherein the chiplets are smaller than 500 micrometers.

8. The method according to any preceding claim, wherein the method further comprises removing the sacrificial wafer by grinding and CMP (Chemical and Mechanical Polishing)

9. The method according to any preceding claim, wherein the method further comprises connecting the chiplets together with fine pitch ReDistribution Layer (RDL).

10. The method according to any preceding claim, wherein the method further comprises stacking further dies in at least one further layer includes preparing fine pitch pads for the further die-stacking.

11. The method according to any preceding claim, wherein forming interconnects for the chiplets includes performing VIA last Through Silicon Via (TSV) to access IO-connections of the chiplets and to realize the interconnects.

12. The method according to any preceding claim, wherein the method further comprises stacking further dies in at least one further layer by:
selecting further good dies for further chiplets;
bonding the selected further good dies to the reconstructed wafer;
filling gaps between the further chiplets thereby forming a further layer;
thinning of the selected good dies;
connecting the further chiplets through damascene RDL and TSV.

## Patentansprüche

1. Verfahren zur Herstellung eines aktiven rekonstruierten Wafers, wobei der rekonstruierte Wafer eine Vielzahl von Chiplets umfasst, wobei das Verfahren **dadurch gekennzeichnet ist, dass** das Verfahren Folgendes umfasst:
Zerteilen (102) eines Chiplets umfassenden Produktwafers, um die Chiplets mittels Plasmazerteilen auf einem Glasträger zu vereinzeln;
Auswählen (104) guter Chips für Chiplets unter Verwendung einer Laserablösung und eines Aufnahmewerkzeugs;
Bonden (106) der ausgewählten guten Chips mit einem Opferwafer;
Füllen (108) von Lücken zwischen Chiplets, wodurch eine erste Schicht gebildet wird, die den aktiven rekonstruierten Wafer bildet;
Ausdünnen (110) der ausgewählten guten Chips;
Bonden (112) des rekonstruierten Wafers mit einem SiliziumWafer;
Entfernen (114) des Opferwafers;
Bonden (116) von Chiplets;
Stapeln (118) weiterer Chips in mindestens einer weiteren Schicht; und dann
Bilden (120) von Verbindern zur Befestigung.

2. Verfahren nach Anspruch 1, wobei
der Produktwafer mittels einer temporären Bonding-Schicht auf den Glasträger gebondet wird,
auf die Rückseite oder die Vorderseite des Produktwafers ein lichtempfindliches Polymer aufgetragen wird,
Plasmazerteilen durchgeführt und die Polymermaske entfernt wird, bevor das temporäre Bonding-Material (Temporary Bonding Material, TBM) aufgeklebt und einer Laserbelichtung unterzogen wird, um die plasmazerteilten Chiplets auf den Rahmen zu überführen.

3. Verfahren nach Anspruch 1 oder 2, wobei der Opferwafer auf Silizium basiert und eine Strukturierung mit Fiducials aufweist.

4. Verfahren nach einem der vorhergehenden Ansprüche, wobei das Verfahren ferner das Bonden der ausgewählten guten Chips mit dem Opferwafer durch Fusionsbonden umfasst.

5. Verfahren nach einem der vorhergehenden Ansprüche, wobei das Verfahren ferner das Füllen von Lücken zwischen Chiplets unter Verwendung von SOG (Spin-On Glass) umfasst.

6. Verfahren nach einem der vorhergehenden Ansprüche, wobei das Verfahren ferner das Abscheiden einer Rückseitenpassivierungsschicht umfasst, um den neuen Siliziumwafer auf eine Rückseite des aktiven rekonstruierten Wafers zu bonden, und wobei die Opferschicht auf einer Vorderseite des aktiven rekonstruierten Wafers gebildet wird.

7. Verfahren nach einem der vorhergehenden Ansprüche, wobei die Chiplets kleiner als 500 Mikrometer sind.

8. Verfahren nach einem der vorhergehenden Ansprüche, wobei das Verfahren ferner das Entfernen des Opferwafers durch Schleifen und CMP (chemisch-mechanisches Polieren) umfasst.

9. Verfahren nach einem der vorhergehenden Ansprüche, wobei das Verfahren ferner das Verbinden der Chiplets miteinander mittels Umverdrahtungschicht (ReDistribution-Layer, RDL) mit geringem Abstand umfasst.

10. Verfahren nach einem der vorhergehenden Ansprüche, wobei das Verfahren ferner das Stapeln weiterer Chips in mindestens einer weiteren Schicht umfasst und das Vorbereiten von Pads mit geringem Abstand für das weitere Chipstapeln beinhaltet.

11. Verfahren nach einem der vorhergehenden Ansprüche, wobei das Bilden von Verbindern für die Chiplets das Ausführen von VIA-last TSV (Through Silicon Via, Silizium-Durchkontaktierung) umfasst, um auf E/A-Verbindungen der Chiplets zuzugreifen und die Verbinder herzustellen.

12. Verfahren nach einem der vorhergehenden Ansprüche, wobei das Verfahren außerdem das Stapeln weiterer Chips in mindestens einer weiteren Schicht umfasst durch:
Auswählen weiterer guter Chips für weitere Chiplets;
Bonden der ausgewählten weiteren guten Chips mit dem rekonstruierten Wafer;
Füllen von Lücken zwischen den weiteren Chiplets, wodurch eine weitere Schicht gebildet wird;
Ausdünnen der ausgewählten guten Chips;
Bonden der weiteren Chiplets mittels Damaszener-RDL und TSV.

## Revendications

1. Procédé de fabrication d'une plaquette active reconstruite, la plaquette reconstruite comprenant une pluralité de micropuces, le procédé étant **caractérisé en ce que** le procédé comprend :
le découpage en dés (102) d'une plaquette de produit comprenant des micropuces pour séparer les micropuces à l'aide d'un découpage au plasma en dés sur un support en verre ;
la sélection (104) de bonnes pièces pour les micropuces à l'aide d'un laser de libération et d'un outil de ramassage ;
la liaison (106) des bonnes pièces sélectionnées à une plaquette sacrificielle ;
le remplissage (108) des espaces entre les micropuces, formant ainsi une première couche formant la plaquette active reconstruite ;
l'amincissement (110) des bonnes pièces sélectionnées ;
la liaison (112) de la plaquette reconstruite à une plaquette de silicium ;
le retrait (114) de la plaquette sacrificielle ;
la connexion (116) des micropuces ;
l'empilage (118) d'autres pièces dans au moins une autre couche ; et ensuite
la formation (120) d'interconnexions destinées à être fixées.

2. Procédé selon la revendication 1, dans lequel
la plaquette de produit est liée à l'aide d'une couche de liaison temporaire sur le support en verre,
un polymère photosensible est appliqué sur la face arrière ou sur la face avant de la plaquette de produit,
le découpage au plasma en dés est réalisé et le masque polymère est retiré avant l'application d'un ruban adhésif et l'exposition au laser du matériau de liaison temporaire (TBM) pour transférer les micropuces découpées au plasma en dés sur le cadre.

3. Procédé selon la revendication 1 ou 2, dans lequel la plaquette sacrificielle est à base de silicium et est dotée de motifs de repérage.

4. Procédé selon une quelconque revendication précédente, dans lequel le procédé comprend également la liaison des bonnes pièces sélectionnées à la plaquette sacrificielle par liaison en fusion.

5. Procédé selon une quelconque revendication précédente, dans lequel le procédé comprend également le remplissage des espaces entre les micropuces à l'aide du procédé SOG (verre déposé par centrifugation).

6. Procédé selon une quelconque revendication précédente, dans lequel le procédé comprend également le dépôt d'une couche de passivation arrière afin de lier la nouvelle plaquette de silicium sur une face arrière de la plaquette active reconstruite et dans lequel la couche sacrificielle est formée sur une face avant de la plaquette active reconstruite.

7. Procédé selon une quelconque revendication précédente, dans lequel les micropuces sont plus petites que 500 micromètres.

8. Procédé selon une quelconque revendication précédente, dans lequel le procédé comprend également le retrait de la plaquette sacrificielle par meulage et par CMP (polissage chimique et mécanique) .

9. Procédé selon une quelconque revendication précédente, dans lequel le procédé comprend également la connexion des micropuces ensemble avec une couche de redistribution (RDL) à pas fin.

10. Procédé selon une quelconque revendication précédente, dans lequel le procédé comprend également l'empilage d'autres pièces dans au moins une autre couche qui comporte la préparation de tampons à pas fin pour l'empilage ultérieur d'autres pièces.

11. Procédé selon une quelconque revendication précédente, dans lequel la formation d'interconnexions pour les micropuces comporte l'exécution d'un VIA traversant (TSV) pour accéder aux connexions IO des micropuces et pour réaliser les interconnexions.

12. Procédé selon une quelconque revendication précédente, dans lequel le procédé comprend également l'empilage d'autres pièces dans au moins une autre couche par :
la sélection d'autres bonnes pièces pour d'autres micropuces ;
la liaison d'autres bonnes pièces sélectionnées à la plaquette reconstruite ;
le remplissage des espaces entre les autres micropuces, formant ainsi une autre couche ;
l'amincissement des bonnes pièces sélectionnées ;
la connexion des autres micropuces à travers une RDL et un TSV damasquinés.
